(19) Europäisches Patentamt / European Patent Office / Office européen des brevets

(11) **EP 4 351 303 B1**

(12) **EUROPEAN PATENT SPECIFICATION**

(45) Date of publication and mention
of the grant of the patent:
**11.06.2025 Bulletin 2025/24**

(21) Application number: **23201356.5**

(22) Date of filing: **03.10.2023**

(51) International Patent Classification (IPC):
**H10N 30/853** *(2023.01)* **B41J 2/14** *(2006.01)*
**B41J 2/16** *(2006.01)* **H10N 30/078** *(2023.01)*
**H10N 30/079** *(2023.01)*

(52) Cooperative Patent Classification (CPC):
**H10N 30/708; B41J 2/14233; B41J 2/161;
B41J 2/1623; B41J 2/1628; B41J 2/1629;
B41J 2/1634; B41J 2/1642; B41J 2/1646;
H10N 30/8542;** B41J 2002/14362;
B41J 2002/14491; B41J 2202/03; H10N 30/078;
H10N 30/079

(54) **PIEZOELECTRIC SUBSTRATE, PIEZOELECTRIC ELEMENT, AND PIEZOELECTRIC ELEMENT APPLICATION DEVICE**

PIEZOELEKTRISCHES SUBSTRAT, PIEZOELEKTRISCHES ELEMENT UND ANWENDUNGSVORRICHTUNG FÜR PIEZOELEKTRISCHES ELEMENT

SUBSTRAT PIÉZOÉLECTRIQUE, ÉLÉMENT PIÉZOÉLECTRIQUE ET DISPOSITIF D'APPLICATION D'ÉLÉMENT PIÉZOÉLECTRIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **03.10.2022 JP 2022159305**

(43) Date of publication of application:
**10.04.2024 Bulletin 2024/15**

(73) Proprietor: **Seiko Epson Corporation
Tokyo 160-8801 (JP)**

(72) Inventors:
• **YANO, Yoshiki**
**392-8502 Suwa-shi (JP)**
• **OHASHI, Koji**
**392-8502 Suwa-shi (JP)**
• **HAMADA, Yasuaki**
**392-8502 Suwa-shi (JP)**
• **KITADA, Kazuya**
**392-8502 Suwa-shi (JP)**

(74) Representative: **Lewis Silkin LLP
Arbor
255 Blackfriars Road
London SE1 9AX (GB)**

(56) References cited:
**EP-A1- 3 336 912          US-A1- 2013 064 970
US-A1- 2014 042 875     US-A1- 2021 036 212**

• **BAIRAGI SATYARANJAN ET AL: "Effects of surface modification on electrical properties of KNN nanorod-incorporated PVDF composites", JOURNAL OF MATERIAL SCIENCE, KLUWER ACADEMIC PUBLISHERS, DORDRECHT, vol. 54, no. 17, 28 May 2019 (2019-05-28), pages 11462 - 11484, XP036804385, ISSN: 0022-2461, [retrieved on 20190528], DOI: 10.1007/S10853-019-03719-X**
• **JI-LAN YANG ET AL: "Synthesis of sodium-potassium niobate (K, Na)NbO 3 lead-free piezoelectric powders using solvothermal and hydrothermal processing", PIEZOELECTRICITY, ACOUSTIC WAVES AND DEVICE APPLICATIONS (SPAWDA), 2010 SYMPOSIUM ON, IEEE, 10 December 2010 (2010-12-10), pages 249 - 253, XP032013554, ISBN: 978-1-4244-9822-2, DOI: 10.1109/SPAWDA.2010.5744314**

**Description**

BACKGROUND

1. Technical Field

The present invention relates to a piezoelectric substrate, a piezoelectric element, and a piezoelectric element application device.

2. Related Art

A piezoelectric element generally includes a substrate, a piezoelectric layer having an electromechanical conversion characteristic, and two electrodes sandwiching the piezoelectric layer. In recent years, devices (piezoelectric element application devices) using such a piezoelectric element as a drive source have been actively developed. One of the piezoelectric element application devices is a liquid ejection head represented by an ink jet recording head, a MEMS element represented by a piezoelectric MEMS element, an ultrasonic measurement device represented by an ultrasonic sensor, and further, a piezoelectric actuator device.

Lead zirconate titanate (PZT) is known as a material (piezoelectric material) for the piezoelectric layer of the piezoelectric element. In recent years, non-lead-based piezoelectric materials having a reduced lead content have been developed from the viewpoint of environmental load reduction.

Further, in recent years, there is a strong demand for further size reduction and higher performance of various electronic devices, electronic components, and the like, and accordingly, size reduction and higher performance of piezoelectric elements are also demanded.

As one of the non-lead-based piezoelectric materials, for example, as disclosed in JP-A-2013-225605, potassium sodium niobate, KNN $(K,Na)NbO_3$ has been proposed.

Generally, when a KNN-based material is used as a piezoelectric material, a problem that a leakage current is likely to be generated is known. In this regard, JP-A-2013-225605 discloses that generation of a leakage current can be prevented by containing at least one of iron and manganese.

However, according to the studies of the inventors, it has been found that a leakage current density is increased due to an organic component remaining in the piezoelectric layer. That is, the leakage current density may not be sufficiently reduced only by improving a crystal orientation by adding an additive into the KNN-based piezoelectric layer.

Under such circumstances, a piezoelectric layer capable of sufficiently reducing a leakage current is demanded in a piezoelectric substrate or a piezoelectric element including a KNN-based piezoelectric layer.

Such a problem is not limited to a piezoelectric element used in a piezoelectric actuator mounted on a liquid ejection head represented by an ink jet recording head, but also exist similarly in a piezoelectric element used in another piezoelectric element application device.

US 2013/064970 discloses a method of preparing a lead-free piezoelectric thin film comprising the steps of: providing a precursor solution comprising at least one alkali metal ion, a polyamine carboxylic acid, and an amine; depositing the precursor solution on a substrate to form a film; and annealing the film. The document also describes a lead-free piezoelectric thin film prepared according to the method, a precursor solution for use in the method and a method of preparing the precursor solution.

EP 3336912 discloses a piezoelectric element that includes a piezoelectric layer composed of a perovskite structure complex oxide containing potassium, sodium, niobium and manganese, disposed between first and second electrodes on a substrate. The manganese includes divalent manganese, trivalent manganese and tetravalent manganese. A molar ratio Mn2+/((Mn3+) + (Mn4+)) ranges from 1 to 10, and a molar ratio K/Na is less than or equal to 1.1.

US 2021/036212 A1 discloses a piezoelectric element comprising a piezoelectric film containing potassium, sodium, niobium, lithium and copper.

SUMMARY

In order to solve the above problem, according to the invention, there is provided a piezoelectric substrate as defined in claim 1.

According to a second aspect of the invention, there is provided a piezoelectric element as defined in claim 6.

According to a third aspect of the invention, there is provided a piezoelectric element application device as defined in claim 7.

BRIEF DESCRIPTION OF THE DRAWINGS

FIG. 1 is a cross-sectional view schematically showing a piezoelectric substrate according to an embodiment.
FIG. 2 is a cross-sectional view schematically showing a piezoelectric element according to the embodiment.
FIG. 3 is a perspective view showing a schematic configuration of a recording device according to the embodiment.
FIG. 4 is an exploded perspective view of a recording head of the recording device in FIG. 3.
FIG. 5 is a plan view of the recording head of the recording device in FIG. 3.
FIG. 6 is a cross-sectional view of the recording head of the recording device in FIG. 3.
FIG. 7 is a graph showing measurement results of Fourier transform infrared spectroscopy of Examples.

DESCRIPTION OF EMBODIMENTS

Hereinafter, embodiments will be described with reference to the drawings. In the drawings, the same reference signs denote the same members, and the description thereof is omitted as appropriate. The number after a letter which makes up the reference sign is referenced by a reference sign which includes the same letter and is used to distinguish between elements which have similar configurations. When it is not necessary to distinguish elements indicated by the reference signs which include the same letter from each other, each of the elements is referenced by a reference sign containing only a letter.

In each drawing, X, Y, and Z represent three spatial axes orthogonal to one another. In the present description, directions along these axes are referred to as a first direction X (X-direction), a second direction Y (Y-direction), and a third direction Z (Z-direction), a direction of an arrow in each drawing is referred to as a positive (+) direction, and a direction opposite from the arrow is referred to as a negative (-) direction. The X-direction and the Y-direction represent in-plane directions of a plate, a layer, and a film, and the Z-direction represents a thickness direction or a stacking direction of a plate, a layer, and a film.

Components shown in each drawing, that is, a shape and size of each part, a thickness of a plate, a layer, and a film, a relative positional relation, a repeating unit, and the like may be exaggerated for describing the present disclosure. Furthermore, the term "above" in the present description does not limit that a positional relation between the components is "directly above". For example, expressions such as "a first electrode on a base body" and "a piezoelectric layer on the first electrode", which will be described later, do not exclude those including other components between the base body and the first electrode or between the first electrode and the piezoelectric layer.

Piezoelectric Substrate

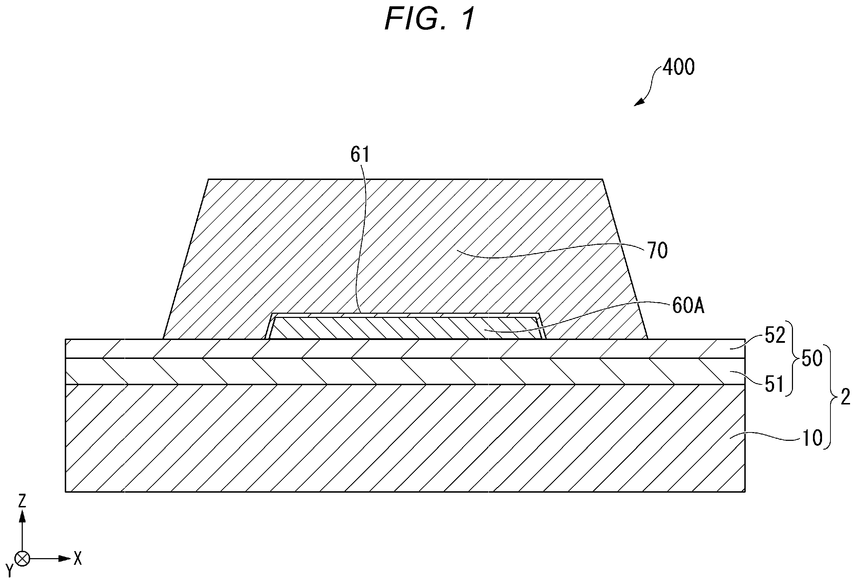

First, a configuration of a piezoelectric substrate 400 according to the embodiment will be described with reference to the drawings. FIG. 1 is a cross-sectional view schematically showing the piezoelectric substrate 400.

As shown, the piezoelectric substrate 400 includes a base body 2, an electrode 60A, and a piezoelectric layer 70. The piezoelectric substrate 400 is provided above the base body 2. In the shown example, the piezoelectric substrate 400 is provided at the base body 2. Thicknesses of the elements shown in the drawings are merely examples, and can be changed without departing from the scope of the present invention.

The base body 2 is a flat plate formed of, for example, a semiconductor or an insulator. The base body 2 may be a single layer or a structure in which a plurality of layers is stacked. An internal structure of the base body 2 is not limited as long as an upper surface thereof has a planar shape, and the base body 2 may have a structure in which a space and the like is formed therein.

The base body 2 includes, for example, a vibration plate 50 that can be deformed by an operation of the piezoelectric layer 70. In the shown example, the vibration plate 50 includes a silicon oxide layer 51 and an oxide layer 52 provided at the silicon oxide layer 51. In the shown example, the base body 2 includes a silicon substrate 10, and the vibration plate 50 is provided at the silicon substrate 10.

The silicon oxide layer 51 is a layer containing silicon and oxygen, and is, for example, a silica ($SiO_2$) layer. The silicon oxide layer 51 may function as an elastic film. The vibration plate 50 may not include the silicon oxide layer 51.

The oxide layer 52 is, for example, a zirconium oxide layer. When the oxide layer 52 is a zirconium oxide layer, the oxide layer 52 is a layer containing zirconium and oxygen, and is, for example, a $ZrO_2$ layer.

The electrode 60A is formed at the base body 2 (the vibration plate 50 in FIG. 1). A shape of the electrode 60A is, for example, a layer shape or a thin film shape. A thickness (a length in a Z-axis direction) of the electrode 60A is, for example, 10 nm or more and 200 nm or less.

Examples of a material of the electrode 60A include various metals such as nickel, iridium, and platinum, conductive oxides thereof (for example, iridium oxide), composite oxides of strontium and ruthenium (SrRuOx: SRO), and composite oxides of lanthanum and nickel (LaNiOx: LNO). The electrode 60A may have a single-layer structure of the materials shown above, or may have a structure in which a plurality of materials is stacked.

The material of the electrode 60A is suitably a noble metal such as platinum (Pt) or iridium (Ir), or an oxide thereof. The material of the electrode 60A may be any material having conductivity.

An adhesion layer (not shown) may be provided between the electrode 60A and the oxide layer 52. The adhesion layer is made of, for example, titanium oxide (TiOx), titanium (Ti), and SiN, and has a function of improving adhesion between the piezoelectric layer 70 and the vibration plate 50. In a case where a titanium oxide (TiOx) layer, a titanium (Ti) layer, or a silicon nitride (SiN) layer is used as the adhesion layer, when the piezoelectric layer 70 is formed, the adhesion layer also functions as a stopper that prevents potassium and sodium, which are constituent elements of the piezoelectric layer 70, from passing through a first electrode 60 and reaching the silicon substrate 10. The adhesion layer may be omitted.

It is preferable that an orientation control layer (seed layer) 61 is provided between the electrode 60A and the piezoelectric layer 70. The orientation control layer 61 functions as an orientation control layer that controls an orientation of a crystal of a piezoelectric body constituting the piezoelectric layer 70. That is, by providing the orientation control layer 61 at the electrode 60A, the crystal of the piezoelectric body constituting the piezoelectric layer 70 can be preferentially oriented in a predetermined plane orientation (for example, (100) plane). By improving the crystal orientation of the piezoelectric layer, it is possible to efficiently utilize domain rotation and improve displacement characteristics. Examples of a material of the orientation control layer 61 include various metals such as titanium, nickel, iridium, and platinum, oxides thereof, and compounds containing bismuth, iron, titanium, and lead.

The piezoelectric layer 70 is formed at the electrode 60A and covers the electrode 60A. The piezoelectric layer 70 contains a composite oxide having a perovskite structure represented by a general formula $ABO_3$ as a main component. In the embodiment, the piezoelectric layer 70 contains a piezoelectric material made of a KNN-based composite oxide represented by Formula (1).

$$(K_X, Na_{1-X})NbO_3 \qquad (1)$$

$$(0.1 \leq X \leq 0.9)$$

The composite oxide represented by Formula (1) is a so-called KNN-based composite oxide. Since the KNN-based composite oxide is a non-lead-based piezoelectric material having a reduced content of lead (Pb) and the like, the KNN-based composite oxide is excellent in biocompatibility and has low environmental load. In addition, since the KNN-based composite oxide is excellent in piezoelectric characteristics among non-lead-based piezoelectric materials, it is advantageous for improving various characteristics.

A relationship between an organic component remaining in the piezoelectric layer 70 (hereinafter referred to as the remaining organic component) and a leakage current will be described below together with new findings obtained by the inventors.

Generally, in the case of a piezoelectric substrate (or a piezoelectric element to be described later) using a KNN-based material as a piezoelectric material as represented by Formula (1), there is known a problem that a leakage current is likely to be generated. For factors of the generation of the leakage current, according to the intensive studies of the inventors, it has been found that a leakage current density increases due to the remaining organic component in the piezoelectric layer, that is, there is a correlation between the remaining organic component and the leakage current density. Further, it has been found that the leakage current density may not be sufficiently reduced only by improving the crystal orientation by adding an additive to the piezoelectric layer, which is known in the related art as one of the methods for reducing a leakage current.

Therefore, in the embodiment, attention is paid to the remaining organic component contained in the piezoelectric layer 70, and a correlation of peaks during measurement by Fourier transform infrared (FT-IR) spectroscopy is defined. Specifically, a value of IR2/IR1 obtained by dividing an integrated intensity IR2 of a peak 2 by an integrated intensity IR1 of a peak 1, when a surface of the piezoelectric layer 70 is measured by FT-IR spectroscopy, is less than 0.086. Here, the peak 1 has a strongest area intensity among peaks detected at wavenumbers of 475 $cm^{-1}$ to 700 $cm^{-1}$, and the peak 2 has an area intensity that is a sum of area intensities of peaks detected at wavenumbers of 1200 $cm^{-1}$ to 1645 $cm^{-1}$. More specifically, in the piezoelectric layer 70 according to the embodiment, the peak 1 corresponds to a peak related to niobium oxide (NbO), and the remaining organic component contained in the piezoelectric layer 70 can be quantitatively evaluated by correlating a peak related to the remaining organic component with the peak 1. When the IR2/IR1 is less than 0.086, the organic component remaining in the piezoelectric layer 70 can be reduced, the leakage current can be sufficiently reduced, and the domain rotation can be added, and thus a displacement amount can be increased. The IR2/IR1 is preferably 0.078 or less.

Since the IR2/IR1 is preferably as small as possible, a lower limit value thereof is not particularly limited. However, when a preferable method of manufacturing the piezoelectric substrate according to the embodiment and the piezoelectric element to be described later is a liquid phase method and the liquid phase method using a precursor solution is used, since the organic component is more likely to remain in the piezoelectric layer 70 than in a gas phase method, for example, the IR2/IR1 may be 0.05 or more.

The piezoelectric layer 70 contains lithium. Lithium has an effect of improving leakage characteristics. Therefore, in order to reduce the leakage current more efficiently, it is effective to contain lithium as the material constituting the piezoelectric layer 70. A content of lithium is preferably 20 mol% or less. When the content of lithium is more than 20 mol%, a different phase may be generated in the piezoelectric layer 70, and a crystal orientation of the piezoelectric body may deteriorate. More preferably, the content of lithium is 10 mol% or less.

The piezoelectric layer 70 also contains copper. Similar to lithium, copper has an effect of improving leakage characteristics. Therefore, in order to reduce the leakage current more efficiently, it is effective to contain copper as the material constituting the piezoelectric layer 70. Among transition metals, elements having a higher effect of improving leakage characteristics are manganese and copper. Both manganese and copper may be contained in the piezoelectric layer 70.

When a content of copper in the piezoelectric layer 70 is more than 5 mol%, a different phase may be generated in the piezoelectric layer 70, and the crystal orientation of the piezoelectric body may deteriorate. Therefore, a total content of copper is preferably 5 mol% or less.

In order to further improve the leakage characteristics, lithium and copper are contained in the piezoelectric layer 70.

An average crystal grain size of the KNN-based composite oxide constituting the piezoelectric layer 70 is preferably 1000 nm or less. When the average crystal grain size of the KNN-based composite oxide is coarse, a residual stress accumulated in the piezoelectric layer 70 is concentrated on an existence region of coarse crystal grains, and cracks may be generated in the piezoelectric layer 70. Therefore, the average crystal grain size of the KNN-based composite oxide is preferably 1000 nm or less, more preferably 300 nm or less. Since the average crystal grain size of the KNN-based composite oxide is preferably small from the viewpoint of preventing the generation of cracks, a lower limit value thereof is not particularly limited, but is, for example, 20 nm or more.

Although the piezoelectric substrate 400 is described above, the piezoelectric material constituting the piezoelectric layer 70 is not limited to a composition represented by Formula (1) as long as the piezoelectric material is the KNN-based composite oxide with Li and Cu. For example, another metal element (additive) may be contained in an A site or a B site of potassium sodium niobate. Examples of such additives include manganese (Mn), barium (Ba), calcium (Ca), strontium (Sr), zirconium (Zr), titanium (Ti), bismuth (Bi), tantalum (Ta), antimony (Sb), iron (Fe), cobalt (Co), silver (Ag), magnesium (Mg), and zinc (Zn). One or more of these additives may be contained. By using the additive, it is easy to improve various characteristics to diversify the configuration and function. In the case of a composite oxide containing other elements, the composite oxide also preferably has an $ABO_3$ type perovskite structure.

In the present specification, the "perovskite type composite oxide containing K, Na, and Nb" is "a composite oxide having an $ABO_3$ type perovskite structure containing K, Na, and Nb", and is not limited to only the composite oxide having the $ABO_3$ type perovskite structure containing K, Na, and Nb. That is, in the present specification, the "perovskite type composite oxide containing K, Na, and Nb" contains a piezoelectric material represented as a mixed crystal containing a composite oxide having the $ABO_3$ type perovskite structure containing K, Na, and Nb (for example, the KNN-based composite oxide shown above) and another composite oxide having the $ABO_3$ type perovskite structure.

The other composite oxide is not limited within the scope of the embodiment, and is preferably a non-lead-based piezoelectric material that does not contain lead (Pb). Accordingly, the piezoelectric substrate 400 is excellent in biocompatibility and has low environmental load.

According to the piezoelectric substrate 400 of the embodiment described above, the remaining organic component in the piezoelectric layer 70 can be reduced, and the leakage current can be reduced.

Piezoelectric Element

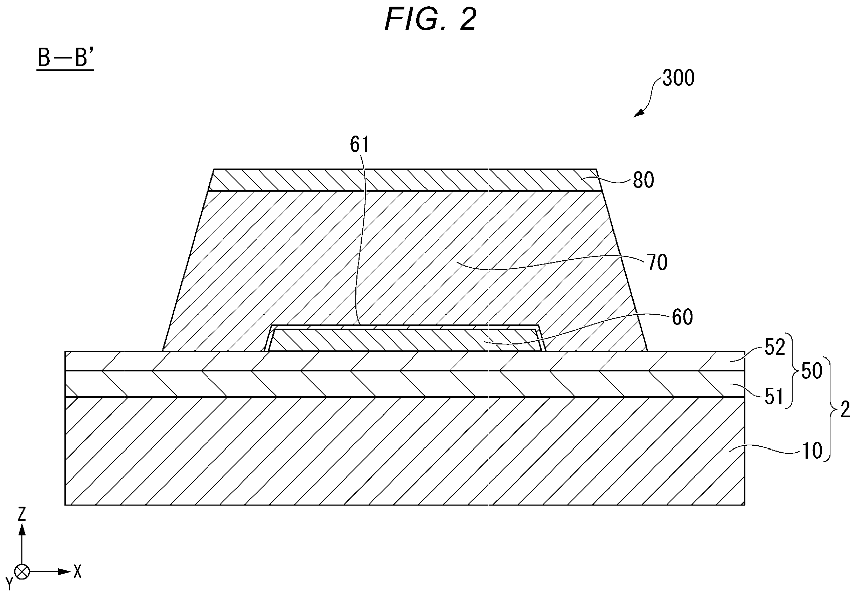

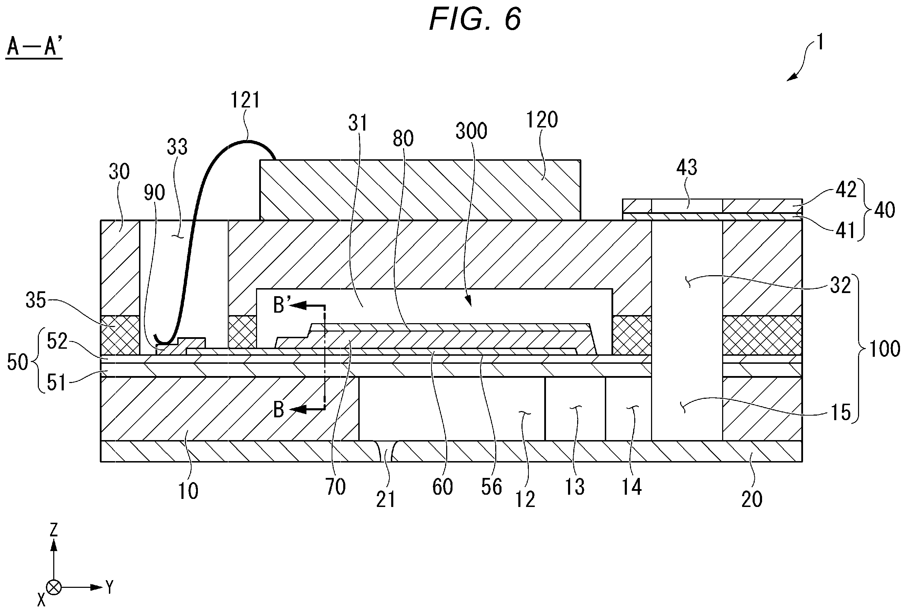

Next, a configuration of a piezoelectric element 300 according to the embodiment will be described with reference to the drawings. FIG. 2 is a cross-sectional view schematically showing the piezoelectric element 300, and is an enlarged cross-sectional view taken along a line B-B' in FIG. 6. In FIGS. 1 and 2, the same reference signs denote the same members, and the description thereof may be omitted as appropriate.

As shown, the piezoelectric element 300 includes the base body 2, the first electrode 60, the piezoelectric layer 70, and a second electrode 80. The piezoelectric element 300 is provided above the base body 2. In the shown example, the piezoelectric element 300 is provided at the base body 2. Thicknesses of the elements shown in the drawings are merely examples, and can be changed without departing from the scope of the present invention.

The configurations, materials, and the like of the base body 2 and the vibration plate 50 may be the same as those of the piezoelectric substrate 400 (see FIG. 1) according to the embodiment. Therefore, the description thereof is omitted.

The first electrode 60 is formed at the base body 2 (the vibration plate 50 in FIG. 2). A shape of the first electrode 60 is, for example, a layer shape or a thin film shape. A thickness (a length in the Z-axis direction) of the first electrode 60 is, for example, 10 nm or more and 200 nm or less. A planar shape (a shape viewed from the Z-axis direction) of the first electrode 60 is not particularly limited as long as the piezoelectric layer 70 can be disposed between the second electrode 80 and the first electrode 60 when the second electrode 80 faces the first electrode 60.

Examples of a material of the first electrode 60 include various metals such as nickel, iridium, and platinum, conductive oxides thereof (for example, iridium oxide), composite oxides of strontium and ruthenium (SrRuOx: SRO), and composite oxides of lanthanum and nickel (LaNiOx: LNO). The first electrode 60 may have a single-layer structure of the materials shown above, or may have a structure in which a plurality of materials is stacked.

The first electrode 60 can be paired with the second electrode 80 to serve as one electrode (for example, a lower electrode formed below the piezoelectric layer 70) for applying a voltage to the piezoelectric layer 70.

The second electrode 80 is formed at the piezoelectric layer 70. The second electrode 80 faces the first electrode 60 with the piezoelectric layer 70 interposed therebetween. A shape of the second electrode 80 is, for example, a layer shape or a thin film shape. A thickness of the second electrode 80 is, for example, 10 nm or more and 200 nm or less. A planar shape of the second electrode 80 is not particularly limited as long as the piezoelectric layer 70 can be disposed between the first electrode 60 and the second electrode 80 when the second electrode 80 faces the first electrode 60.

As a material of the second electrode 80, for example, the materials listed above as the material of the first electrode 60 can be applied. However, in order to make a ratio of a Young's modulus of the piezoelectric layer 70 to a Young's modulus of the second electrode 80 satisfy the above range, platinum (Pt) or iridium (Ir) is preferably used as the material of the second electrode 80.

As one of the functions of the second electrode 80, the paired second electrode 80 and first electrode 60 serve as another electrode (for example, an upper electrode formed above the piezoelectric layer 70) for applying a voltage to the piezoelectric layer 70.

The materials of the first electrode 60 and the second electrode 80 both are suitably a noble metal such as platinum (Pt) or iridium (Ir), or an oxide thereof. The material of the first electrode 60 and the material of the second electrode 80 may be materials having conductivity. The material of the first electrode 60 and the material of the second electrode 80 may be the same or different.

An adhesion layer (not shown) may be provided between the first electrode 60 and the oxide layer 52. The adhesion layer is made of, for example, titanium oxide ($TiO_X$), titanium (Ti), and SiN, and has a function of improving adhesion between the piezoelectric layer 70 and the vibration plate 50. In a case where a titanium oxide ($TiO_X$) layer, a titanium (Ti) layer, or a silicon nitride (SiN) layer is used as the adhesion layer, when the piezoelectric layer 70 is formed, the adhesion layer also functions as a stopper that prevents potassium and sodium, which are constituent elements of the piezoelectric layer 70, from passing through the first electrode 60 and reaching the silicon substrate 10. The adhesion layer may be omitted.

The orientation control layer (seed layer) 61 is preferably provided between the first electrode 60 and the piezoelectric layer 70. The orientation control layer 61 functions as an orientation control layer that controls the orientation of the crystal of the piezoelectric body constituting the piezoelectric layer 70. That is, by providing the orientation control layer 61 at the first electrode 60, the crystal of the piezoelectric body constituting the piezoelectric layer 70 can be preferentially oriented in a predetermined plane orientation (for example, (100) plane). By improving the crystal orientation of the piezoelectric layer, it is possible to efficiently utilize the domain rotation and improve the displacement characteristics. Examples of the material of the orientation control layer 61 include various metals such as titanium, nickel, iridium, and platinum, oxides thereof, and compounds containing bismuth, iron, titanium, and lead.

The piezoelectric layer 70 is formed at the first electrode 60 and covers the first electrode 60. The piezoelectric layer 70 contains a composite oxide having a perovskite structure represented by a general formula $ABO_3$ as a main component. In the embodiment, the piezoelectric layer 70 contains a piezoelectric material made of the KNN-based composite oxide represented by Formula (1).

Definitions of the configuration, the material, the IR2/IR1, the lithium, and the copper of the piezoelectric layer 70 can be adopted as those of the piezoelectric substrate 400 according to the embodiment.

According to the piezoelectric element 300 of the embodiment described above, the remaining organic component in the piezoelectric layer 70 can be reduced, and the leakage current can be reduced.


Method of Manufacturing Piezoelectric Element

Next, an example of a method of manufacturing the piezoelectric element 300 will be described. Hereinafter, a case where the piezoelectric layer 70 is manufactured by a chemical solution method (also referred to as a wet method or a liquid phase method) will be described as an example.

First, the silicon substrate 10 is prepared, and the silicon substrate 10 is thermally oxidized to form the silicon oxide layer 51 made of silicon dioxide (SiO$_2$) on a surface of the silicon substrate 10.

Next, the oxide layer 52 made of zirconium oxide (ZrO$_2$) is formed at the silicon oxide layer 51 by atomic layer deposition (ALD). A film formation temperature is, for example, from 450°C to 850°C. The oxide layer 52 can be formed by a sputtering method, a vapor deposition method, and the like in addition to ALD. First, a zirconium film is formed at the silicon oxide layer 51 by, for example, the sputtering method or the vapor deposition method, and the zirconium film is thermally oxidized to obtain the oxide layer 52 made of zirconium oxide (ZrO$_2$). In this manner, the vibration plate 50 including the silicon oxide layer 51 and the oxide layer 52 is formed at the silicon substrate 10.

Next, an adhesion layer made of metal titanium (Ti) is formed at the oxide layer 52. The adhesion layer can be formed by the sputtering method and the like. Next, the first electrode 60 made of platinum (Pt) is formed at the adhesion layer. The first electrode 60 can be appropriately selected according to an electrode material, and can be formed by, for example, vapor phase film formation such as a sputtering method, a physical vapor deposition method (PVD method), or a laser ablation method, or liquid phase film formation such as a spin coating method.

Next, the orientation control layer (seed layer) 61 is formed at the first electrode 60. The orientation control layer 61 can be formed by, for example, a chemical solution method (wet method) in which a solution (precursor solution) containing a metal complex is applied, then is dried and degreased, and then fired at a high temperature to obtain a metal oxide. Examples of the material of the orientation control layer 61 include various metals such as bismuth, iron, titanium, lead, nickel, iridium, and platinum, and oxides thereof.

Next, a resist having a predetermined shape is formed at the first electrode 60 as a mask, and the adhesion layer, the first electrode 60, and the orientation control layer 61 are simultaneously patterned. The adhesion layer, the first electrode 60, and the orientation control layer 61 can be patterned by, for example, reactive ion etching (RIE), dry etching such as ion milling, or wet etching using an etchant. Shapes of the adhesion layer, the first electrode 60, and the orientation control layer 61 in the patterning are not particularly limited.

Next, a plurality of piezoelectric films is formed at the first electrode 60.

The piezoelectric layer 70 includes the plurality of piezoelectric films. The piezoelectric layer 70 can be formed by, for example, a chemical solution method (wet method) in which a solution (precursor solution) containing a metal complex is applied and dried, and then fired at a high temperature to obtain a metal oxide. In addition, the piezoelectric layer 70 can be formed by a laser ablation method, a sputtering method, a pulse laser deposition method (PLD method), a chemical vapor deposition (CVD) method, an aerosol deposition method, and the like.

For example, the piezoelectric layer 70 formed by the wet method (liquid phase method) includes a plurality of piezoelectric films formed by a series of steps including a step (applying step) of applying a precursor solution and forming a precursor film, a step (drying step) of drying the precursor film, a step (degreasing step) of heating and degreasing the dried precursor film, and a step (firing step) of firing the degreased precursor film. That is, the piezoelectric layer 70 is formed by repeating the series of steps from the applying step to the firing step a plurality of times. In the series of steps described above, the firing step may be performed after repeating the steps from the applying step to the degreasing step a plurality of times.

A specific procedure for forming the piezoelectric layer 70 by the wet method (liquid phase method) is, for example, as follows.

First, a precursor solution containing a predetermined metal complex is prepared. The precursor solution is obtained by, in an organic solvent, dissolving or dispersing a metal complex capable of forming a composite oxide containing K, Na, and Nb by firing. At this time, a metal complex containing an additive such as Mn, Li, or Cu may be further mixed. By mixing the metal complex containing Mn, Li, or Cu with the precursor solution, it is possible to further increase insulation of the obtained piezoelectric layer 70.

Examples of a metal complex containing potassium (K) include potassium 2-ethylhexanoate and potassium acetate. Examples of a metal complex containing sodium (Na) include sodium 2-ethylhexanoate and sodium acetate. Examples of a metal complex containing niobium (Nb) include niobium 2-ethylhexanoate and pentaethoxyniobium. When Mn is added as the additive, examples of a metal complex containing Mn include manganese 2-ethylhexanoate. When Li is added as the additive, examples of a metal complex containing Li include lithium 2-ethylhexanoate. When Cu is added as the additive, examples of a metal complex containing Cu include copper 2-ethylhexanoate. At this time, two or more kinds of metal complexes may be used in combination. For example, potassium 2-ethylhexanoate and potassium acetate may be used in combination as the metal complex containing potassium (K). Examples of a solvent include 2-n-butoxyethanol, n-octane, and mixed solvents thereof. The precursor solution may contain an additive which stabilizes dispersion of the metal complex containing K, Na, and Nb. Examples of such an additive include 2-ethylhexanoate.

The precursor solution is applied onto the silicon substrate 10 on which the silicon oxide layer 51, the oxide layer 52, and the first electrode 60 are formed to form the precursor film (applying step).

Next, the precursor film is heated to a predetermined temperature, for example, about 130°C to 250°C and dried for a certain period of time (drying step).

Next, the dried precursor film is heated to a predetermined temperature, for example, 250°C to 450°C, and is held at this temperature for a certain period of time to perform degreasing, thereby removing an organic component in the precursor film (degreasing step).

Next, the precursor film after degreasing is heated to 500°C to 800°C and is fired by being held at this temperature for 1 minute to 10 minutes (firing step). When the held temperature is too high, the crystal orientation may deteriorate. On the other hand, when the held temperature is too low, firing may be insufficient. Therefore, in the embodiment, the held temperature is preferably 500°C to 800°C. An average heating rate in the firing step is preferably 60°/s or less. When the average heating rate is too fast, a time until crystallization is completed is short, and the organic component tends to remain in the precursor film. Therefore, the average heating rate is preferably 60°C/s or less.

Examples of a heating device used in the drying step, the degreasing step, and the firing step include a rapid thermal annealing (RTA) device which performs heating by irradiation with an infrared lamp, and a hot plate. The above steps are repeated a plurality of times to form the piezoelectric layer 70 including the plurality of piezoelectric films. In the series of steps from the applying step to the firing step, the firing step may be performed after repeating the steps from the applying step to the degreasing step a plurality of times.

Before and after the second electrode 80 is formed at the piezoelectric layer 70, a reheat treatment (post-annealing) may be performed in a temperature range of 600°C to 800°C as necessary. By performing the post-annealing in this way, a good interface between the piezoelectric layer 70 and the first electrode and a good interface between the piezoelectric layer 70 and the second electrode 80 can be formed. Crystallinity of the piezoelectric layer 70 can be improved, and the insulation of the piezoelectric layer 70 can be further increased.

After the firing step, the piezoelectric layer 70 including the plurality of piezoelectric films is patterned into a desired shape. Patterning can be performed by dry etching such as reactive ion etching or ion milling, or wet etching using an etchant.

Thereafter, the second electrode 80 is formed at the piezoelectric layer 70. The second electrode 80 can be formed by the same method as the first electrode 60.

By the above steps, the piezoelectric element 300 including the first electrode 60, the piezoelectric layer 70, and the second electrode 80 is manufactured.

Piezoelectric Element Application Device

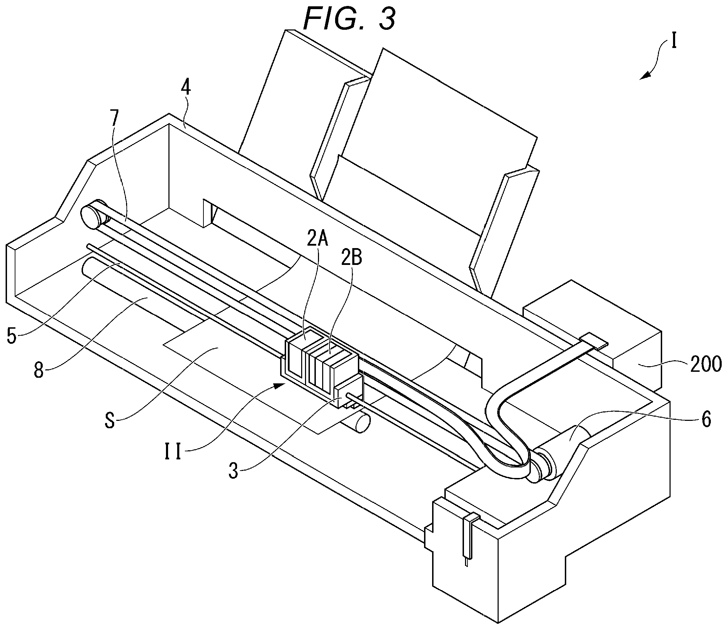

Next, an ink jet recording device, which is an example of a liquid ejection device including a recording head which is an example of a piezoelectric element application device according to the embodiment, will be described with reference to the drawings. FIG. 3 is a perspective view showing a schematic configuration of the ink jet recording device.

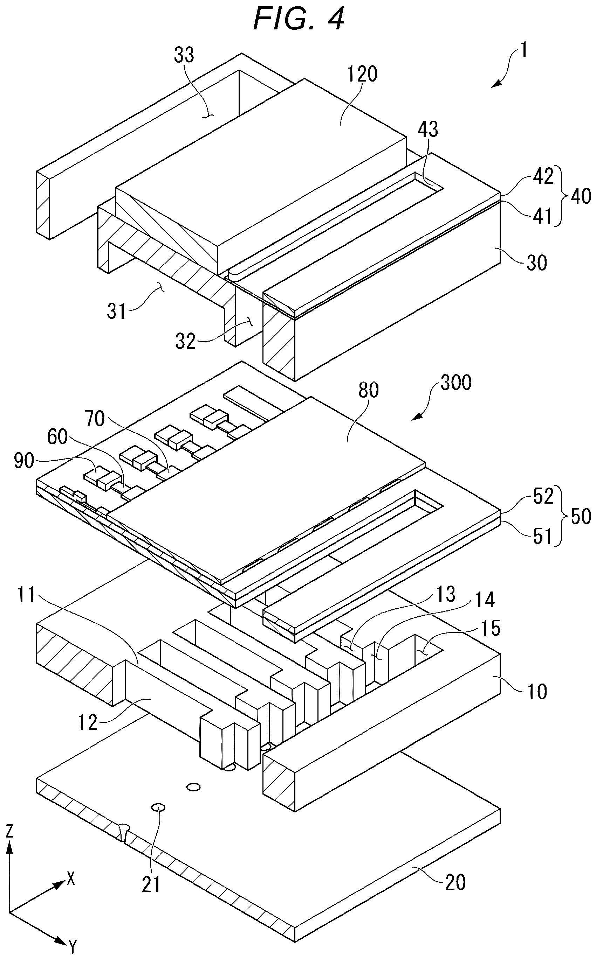

As shown in FIG. 3, in an ink jet recording device (recording device) I, an ink jet recording head unit (head unit) II is detachably provided in cartridges 2A and 2B. The cartridges 2A and 2B constitute an ink supply unit. The head unit II includes a plurality of ink jet recording heads (recording heads) 1 (see FIG. 4 and the like), and is mounted on a carriage 3. The carriage 3 is movable in an axial direction on a carriage shaft 5 attached to a device main body 4. The head unit II and the carriage 3 can dispense, for example, a black ink composition and a color ink composition, respectively.

A driving force of a drive motor 6 is transmitted to the carriage 3 via a plurality of gears (not shown) and a timing belt 7, such that the carriage 3 on which the head unit II is mounted is moved along the carriage shaft 5. On the other hand, the device main body 4 is provided with a conveyance roller 8 as a conveyance unit, and a recording sheet S which is a recording medium such as paper is conveyed by the conveyance roller 8. The conveyance unit which conveys the recording sheet S is not limited to the conveyance roller, and may be a belt, a drum, and the like.

In the recording head (head chip) 1, the piezoelectric element 300 (see FIG. 2) is used as a piezoelectric actuator device. By using the piezoelectric element 300, it is possible to avoid deterioration of various characteristics (piezoelectric characteristics, durability, ink ejection characteristics, and the like) in the recording device I. The piezoelectric element application device according to the embodiment can improve, in particular, the piezoelectric characteristics (in particular, leakage characteristics) by applying the piezoelectric element 300.

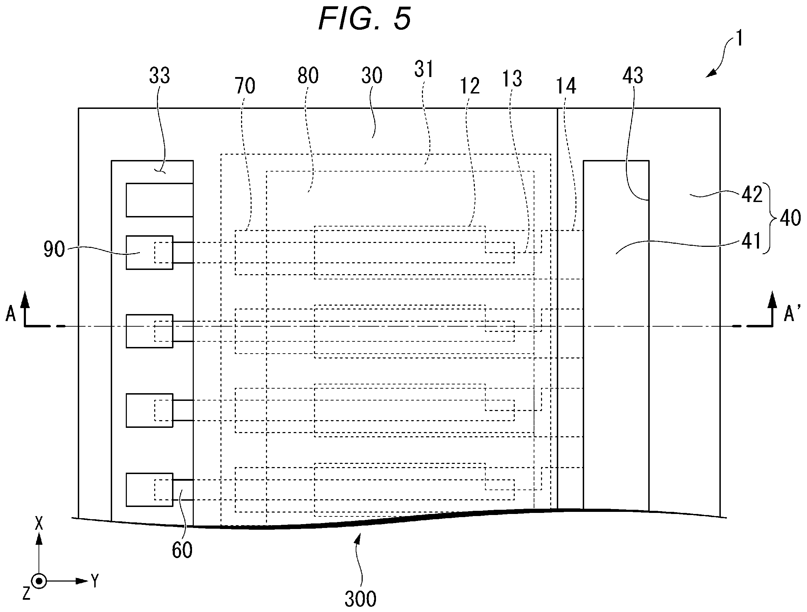

Next, the recording head (head chip) 1 as an example of the head chip mounted on the liquid ejection device will be described with reference to the drawings. FIG. 4 is an exploded perspective view showing the schematic configuration of the ink jet recording head. FIG. 5 is a plan view showing the schematic configuration of the inkjet recording head. FIG. 6 is a cross-sectional view taken along a line A-A' in FIG. 5. FIGS. 4 to 6 each show a part of a configuration of the recording head 1, and are omitted as appropriate.

As shown in the drawings, the recording head (head chip) 1 includes a nozzle plate 20 having nozzle openings 21 for dispensing liquid droplets, pressure generation chambers 12 communicating with the nozzle openings 21, partition walls 11 provided at the nozzle plate 20 and forming the pressure generation chambers 12, the flow path forming substrate (silicon substrate) 10 forming a part of wall surfaces of the pressure generation chambers 12, the piezoelectric element 300 provided at the silicon substrate 10, and lead electrodes (voltage application units) 90 applying a voltage to the piezoelectric element 300.

A plurality of partition walls 11 are formed in the silicon substrate 10. A plurality of pressure generation chambers 12 are partitioned by the partition walls 11. That is, in the substrate 10, the pressure generation chambers 12 are arranged side by side along the X-direction (the direction in which the nozzle openings 21 that dispense ink of the same color are arranged side by side). With such a configuration, a movable portion of the piezoelectric element 300 is formed. As the silicon substrate 10, for example, a silicon single crystal substrate can be used.

In the silicon substrate 10, ink supply paths 13 and communication paths 14 are formed at one end portion side (+Y-direction side) of each of the pressure generation chambers 12. Each of the ink supply paths 13 is formed such that an area of an opening on the one end portion side of the pressure generation chamber 12 is reduced. Each of the communication paths 14 has substantially the same width as the pressure generation chamber 12 in the +X-direction. A communication portion 15 is formed at an outer side (+Y-direction side) of the communication paths 14. The communication portion 15 constitutes a part of a manifold 100. The manifold 100 serves as a common ink chamber for each pressure generation chamber 12. Therefore, liquid flow paths each including the pressure generation chamber 12, the ink supply path 13, the communication path 14, and the communication portion 15 are formed in the silicon substrate 10.

The nozzle plate 20 made of, for example, SUS is bonded to one surface (a surface on a -Z-direction side) of the silicon substrate 10. In the nozzle plate 20, the nozzle openings 21 are arranged side by side along the +X-direction. The nozzle openings 21 communicate with the pressure generation chambers 12. The nozzle plate 20 can be bonded to the silicon substrate 10 by an adhesive, a thermal welding film, and the like.

The vibration plate 50 is formed at the other surface (surface on a +Z-direction side) of the silicon substrate 10. The vibration plate 50 includes, for example, the silicon oxide layer 51 formed at the silicon substrate 10 and the oxide layer 52 formed at the silicon oxide layer 51. The silicon oxide layer 51 is made of, for example, silicon dioxide ($SiO_2$), and the oxide layer 52 is made of, for example, zirconium oxide ($ZrO_2$). The silicon oxide layer 51 may not be a member separated from the silicon substrate 10. A part of the silicon substrate 10 may be thinned and used as the silicon oxide layer 51. The oxide layer 52 functions as a stopper that prevents potassium and sodium, which are constituent elements of the piezoelectric layer 70, from passing through the first electrode 60 and reaching the substrate 10 when the piezoelectric layer 70 described later is formed.

The first electrode 60 is provided for each pressure generation chamber 12. That is, the first electrode 60 is provided as an individual electrode that is independent for each pressure generation chamber 12. The first electrode 60 has a width smaller than a width of the pressure generation chamber 12 in $\pm$X-directions. The first electrode 60 has a width larger than the width of the pressure generation chamber 12 in $\pm$Y-directions. That is, in the $\pm$Y-directions, both end portions of the first electrode 60 are formed up to an outer side of a region on the vibration plate 50 facing the pressure generation chamber 12. The lead electrode (voltage application units) 90 that apply a voltage to the piezoelectric element 300 are coupled to one end portion side (opposite side from the communication paths 14) of the first electrodes 60.

The piezoelectric layer 70 is provided between the first electrode 60 and the second electrode 80. The piezoelectric layer 70 is a thin-film piezoelectric body. The piezoelectric layer 70 has a width larger than the width of the first electrode 60 in the $\pm$X-directions. In the $\pm$Y-directions, the piezoelectric layer 70 has a width larger than a length of the pressure generation chamber 12 in the $\pm$Y-directions. An end portion of the piezoelectric layer 70 on the ink supply path 13 side (the +Y-direction side) is formed up to an outer side of an end portion of the first electrode 60 on the +Y-direction side. That is, the end portion of the first electrode 60 on the +Y-direction side is covered with the piezoelectric layer 70. On the other hand, an end portion of the piezoelectric layer 70 on the lead electrode 90 side (the -Y-direction side) is on an inner side (the +Y-direction side) of an end portion of the first electrode 60 on the -Y-direction side. That is, the end portion of the first electrode 60 on the -Y-direction side is not covered with the piezoelectric layer 70.

The second electrode 80 is continuously provided at the piezoelectric layer 70 and the vibration plate 50 over the +X-direction. That is, the second electrode 80 is implemented as a common electrode common to the plurality of piezoelectric layers 70. In the embodiment, the first electrode 60 constitutes an individual electrode independently provided corresponding to the pressure generation chamber 12, and the second electrode 80 constitutes a common electrode continuously provided in a direction in which the pressure generation chambers 12 are arranged side by side. Alternatively, the first electrode 60 may constitute the common electrode, and the second electrode 80 may constitute the individual electrode.

In the piezoelectric element 300 according to the embodiment, the vibration plate 50 and the first electrode 60 are displaced by the displacement of the piezoelectric layer 70 having electromechanical conversion characteristics. That is, the vibration plate 50 and the first electrode 60 substantially function as vibration plates. However, in practice, since the second electrode 80 is also displaced due to the displacement of the piezoelectric layer 70, a region in which the vibration plate 50, the first electrode 60, the piezoelectric layer 70, and the second electrode 80 are sequentially stacked functions as the movable portion (also referred to as a vibration portion) of the piezoelectric element 300.

On the substrate 10 (the vibration plate 50) at which the piezoelectric element 300 is formed, a protective substrate 30 is bonded by an adhesive 35. The protective substrate 30 has a manifold portion 32. At least a part of the manifold 100 is implemented by the manifold portion 32. The manifold portion 32 according to the embodiment penetrates the protective substrate 30 in the thickness direction (the Z-direction), and is further formed over a width direction (+X-direction) of the pressure generation chamber 12. The manifold portion 32 communicates with the communication portion 15 on the substrate 10. With this configuration, the manifold 100 which is an ink chamber common to the pressure generation chambers 12 is formed.

The protective substrate 30 has a piezoelectric element holding portion 31 formed in a region including the piezoelectric element 300. The piezoelectric element holding portion 31 has enough space not to interfere with a movement of the piezoelectric element 300. This space may or may not be sealed. The protective substrate 30 is provided with a through hole 33 penetrating the protective substrate 30 in the thickness direction (the Z-direction). An end portion of each of the lead electrodes 90 is exposed in the through hole 33.

Examples of a material of the protective substrate 30 include Si, SOI, glass, a ceramic material, a metal, and a resin, and the protective substrate 30 is more preferably formed of a material having substantially the same thermal expansion coefficient as that of the substrate 10.

A drive circuit 120 functioning as a signal processing unit is fixed at the protective substrate 30. As the drive circuit 120, for example, a circuit board or a semiconductor integrated circuit (IC) can be used. The drive circuit 120 and the lead electrodes 90 are electrically coupled to each other via coupling interconnects 121 each of which is made of a conductive wire such as a bonding wire and which are inserted through the through hole 33. The drive circuit 120 can be electrically coupled to a printer controller 200 (see FIG. 2). Such a drive circuit 120 functions as a control unit for the piezoelectric actuator device (the piezoelectric element 300).

On the protective substrate 30, a compliance substrate 40 including a sealing film 41 and a fixing plate 42 is bonded. The sealing film 41 is made of a material having low rigidity, and the fixing plate 42 can be made of a hard material such as a metal. A region of the fixing plate 42 facing the manifold 100 is an opening portion 43 with a part completely removed in the thickness direction (the Z-direction). One surface (a surface on the +Z-direction side) of the manifold 100 is sealed only with the sealing film 41 having flexibility.

Such a recording head 1 dispenses ink droplets by the following operation.

First, ink is taken in from an ink introduction port coupled to an external ink supply unit (not shown), and an inside of the recording head 1 is filled with the ink from the manifold 100 to the nozzle openings 21. Thereafter, according to a recording signal from the drive circuit 120, a voltage is applied between the first electrode 60 and the second electrode 80 corresponding to each pressure generation chamber 12, and the piezoelectric element 300 is deflected and deformed. Accordingly, a pressure in each pressure generation chamber 12 is increased, and ink droplets are dispensed from the nozzle openings 21.

In the above embodiment, the ink jet recording head is described as an example of a liquid ejection head. However, the present invention is applicable to liquid ejection heads in general, and is also applicable to a liquid ejection head for ejecting liquid other than ink. Examples of other liquid ejection heads include various recording heads used in image recording devices such as printers, color material ejection heads used for manufacturing color filters for liquid crystal displays, electrode material ejection heads used for forming electrodes for organic EL displays and field emission displays (FEDs), and bioorganic material ejection heads used for manufacturing biochips.

The present invention is not limited to the piezoelectric element mounted on the liquid ejection head, and can also be applied to a piezoelectric element mounted on another piezoelectric element application device. Examples of the piezoelectric element application device include an ultrasonic device, a motor, a pressure sensor, a pyroelectric element, and a ferroelectric element. Completed bodies using these piezoelectric element application devices, for example, an ejection device of the liquid and the like using an ejection head for the liquid and the like, an ultrasonic sensor using the ultrasonic device, a robot using the motor as a drive source, an IR sensor using the pyroelectric element, and a ferroelectric memory using the ferroelectric element are also in the piezoelectric element application device.

In particular, the piezoelectric element according to the present invention is suitable as a piezoelectric element mounted on a sensor. Examples of the sensor include a gyro sensor, an ultrasonic sensor, a pressure sensor, and a speed and acceleration sensor. When the piezoelectric element according to the present invention is applied to a sensor, for example, a voltage detection unit which detects a voltage output from the piezoelectric element 300 can be provided between the first electrode 60 and the second electrode 80 to form the sensor. In a case of such a sensor, when the piezoelectric element 300 is deformed due to some external change (change in physical quantity), a voltage is generated according to the deformation. Various physical quantities can be detected by detecting the voltage with the voltage detection unit.

Examples

Hereinafter, the present invention will be described in more detail with reference to Examples, and the present invention is not limited to these Examples.

Example 1

First, a surface of a silicon substrate (6 inches (= 15.24 cm); (110) plane orientation) as a substrate was thermally oxidized to form a silicon oxide layer (1460 nm) made of silicon dioxide at the substrate. Further, a $ZrO_2$ film was formed at the silicon oxide layer by an ALD method to form an oxide layer (400 nm) made of zirconium oxide. A film formation temperature was 850°C. In this manner, a vibration plate including the silicon oxide layer and the oxide layer was formed at the silicon substrate.

Next, an adhesion layer (20 nm) made of titanium (Ti) was formed at the vibration plate by a sputtering method, and a first electrode containing platinum (Pt) and iridium was formed at the adhesion layer by the sputtering method. The first electrode is formed by sequentially stacking a layer (80 nm) containing platinum (Pt) and a layer (5 nm) containing iridium (Ir) at the adhesion layer.

Next, an orientation control layer (seed layer) was formed at the first electrode by the following procedure.

First, a propionic acid solution of bismuth, iron, titanium, and lead was prepared such that Bi : Pb : Fe : Ti = 110 : 10 : 50 : 50. The solution was applied onto the first electrode by a spin coating method. Thereafter, the applied solution was dried/degreased using a hot plate, and subjected to a heat treatment using rapid thermal annealing (RTA) to form the orientation control layer. Film formation conditions of the orientation control layer are as shown in Table 1.

Table 1

| | | |
|---|---|---|
| Film formation condition of orientation control layer | Coat | Drop amount: 3 cc, spin conditions: 500 rpm, 5.6 se →3000 rpm, 20.4 sec_-→slope, 5 sec |
| | Dry | 180°C, 3 min |
| | Degrease | 380°C, 3 min |
| | Fire | 650°C, 3 min (warming time: 10 sec heating rate: 60°C/sec $O_2$ gas: 100 sccm) |
| Film formation condition of piezoelectric layer | Coat | Drop amount: 60 μL, spin conditions: 500 rpm, 5.6 sec→3000 rpm, 20.4 sec→slope, 5 sec |
| | Dry | 180°C, 3 min |
| | Degrease | 380°C, 3 min |
| | Fire | 700°C, 3 min (warming time: 10 sec heating rate: 10°C/sec $O_2$ gas: 100 sccm) |

Next, a piezoelectric layer was formed at the vibration plate by the following procedure.

First, a precursor solution containing potassium 2-ethylhexanoate, sodium 2-ethylhexanoate, lithium 2-ethylhexanoate, niobium 2-ethylhexanoate, manganese 2-ethylhexanoate, and copper 2-ethylhexanoate was used to prepare $K_{0.5136}Na_{0.4934}Li_{0.053}Nb_{0.99}Mn_{0.005}Cu_{0.005}O_x$, and the precursor solution was applied onto the orientation control layer by the spin coating method to form a precursor film (applying step). Thereafter, the precursor film was dried (drying step), and then degreased (degreasing step). Next, the degreased precursor film was subjected to a heat treatment using the rapid thermal annealing (RTA) to form a piezoelectric film (firing step). Upper limits of the applying step, the drying step, the degreasing step, and the firing step are as shown in Table 1.

The steps from the applying step to the firing step were repeated five times to produce a piezoelectric layer made of five piezoelectric films and having a total film thickness of 400 nm.

A second electrode (50 nm) made of platinum (Pt) was formed at the obtained piezoelectric layer by a sputtering method in the same manner as the first electrode, thereby obtaining a piezoelectric element.

Example 2

Example 2 was the same as Example 1 except that a composition of the piezoelectric layer was $K_{0.5136}Na_{0.4934}Li_{0.053}Nb_{0.99}Cu_{0.01}O_x$.

Comparative Example 1

Comparative Example 1 was the same as Example 1 except that the composition of the piezoelectric layer was $K_{0.5136}Na_{0.4934}Li_{0.053}Nb_{0.99}Mn_{0.005}O_x$.

Comparative Example 2

Comparative Example 2 was the same as Example 1 except that the composition of the piezoelectric layer was $K_{0.5}Na_{0.5}Nb_{0.995}Mn_{0.005}O_x$, and manufacturing conditions were as shown in Table 2.

Table 2

| Film formation condition of orientation control layer | Coat | Drop amount: 3 cc, spin conditions: 500 rpm, 5.6 sec→3000 rpm, 20.4 s →slope, 5 sec |
|---|---|---|
| | Dry | 180°C, 3 min |
| | Degrease | 380°C, 3 min |
| | Fire | 650°C, 3 min (warming time: 10 sec , heating rate: 60°C/sec $O_2$ gas: 100 sccm) |
| Film formation condition of piezoelectric layer | Coat | Drop amount: 60 μL, spin conditions: 500 rpm, 5.6 sec →3000 rpm, 20.4 sec→slope, 5 sec |
| | Dry | 180°C, 3 min |
| | Degrease | 380°C, 3 min |
| | Fire | 750°C, 3 min (warming time: 10 sec , heating rate: 60°C/sec $O_2$ gas: 100 sccm) |

In each of Examples and Comparative Examples described above, the obtained piezoelectric layer was subjected to FT-IR spectroscopy.

FT-IR Spectroscopy

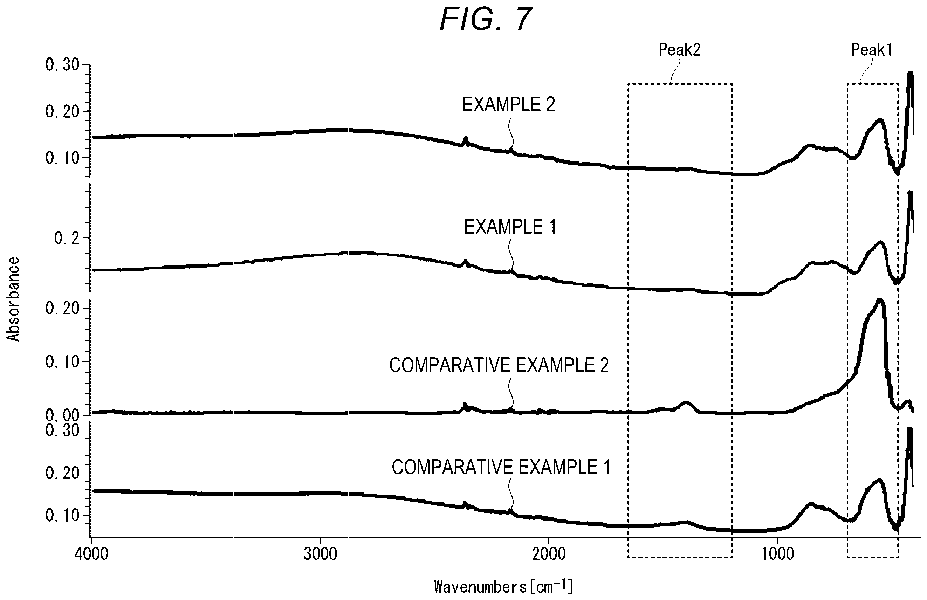

Measurement was performed by the ATR method using FT/IR-4700 (detector: TGS) manufactured by JASCO Corporation. Diamond was used as an ATR crystal, and the ATR crystal was pressed in close contact with a sample. A measurement region was set to 4000 cm$^{-1}$ to 400 cm$^{-1}$, a resolution was set to 4 cm$^{-1}$, and the number of times of integration was set to 32. FIG. 7 shows FT-IR spectroscopy results of Examples 1 and 2 and Comparative Examples 1 and 2. In FIG. 7, analysis results of Examples 1 and 2 and Comparative Examples 1 and 2 are shown side by side along a vertical axis direction in order to facilitate comparison of the analysis results.

Leakage Current Measurement

A leakage current of the obtained piezoelectric element was measured using a pA meter (4140B, manufactured by Hewlett-Packard Company). As measurement conditions, a delay time was set to 10 seconds, a first electrode side was used as a drive for measurement, and a leakage current at an electric field intensity of 500 kV/cm was measured.

Test Results

Table 3 shows leakage current measurement results at an electric field intensity of 500 kV/cm in Examples 1 and 2 and Comparative Example 1. In Comparative Examples, after the piezoelectric layer is formed, the surface of the piezoelectric layer was observed by a scanning electron microscope (SEM). Since occurrence of cracks was confirmed, a leakage current density was not measured.

The measurement results are shown in Tables 3 and 4. In Table 3, "BE" means the first electrode, and "TE" means the second electrode. In Table 3, "E-0x" in a "leakage current amount" represents "$\times 10^{-x}$". For example, "2.71E-07" means "$2.71 \times 10^{-7}$".

Table 3

| Sample | Example 1 | Example 2 | Comparative Example 1 |
|---|---|---|---|
| BE + leakage current amount (A/cm$^2$) | 2.71E-07 | 8.51E-07 | 2.72E-02 |
| TE + leakage current amount (A/cm$^2$) | 6.46E-08 | 2.63E-07 | 4.44E-02 |

Table 4

| | Peak 1 wavenumber range/cm$^{-1}$ | Peak 1 area intensity/a.u. | Peak 2 wavenumber range/cm$^{-1}$ | Peak 2 area intensity/a.u. | Standardization IR2/IR1 |
|---|---|---|---|---|---|
| Example 2 | 475-675 | 9.854 | 1208-1644 | 0.772 | 0.078 |
| Example 1 | 479-663 | 9.343 | 1208-1644 | 0.511 | 0.055 |

(continued)

| | Peak 1 wavenumber range/cm$^{-1}$ | Peak 1 area intensity/a.u. | Peak 2 wavenumber range/cm$^{-1}$ | Peak 2 area intensity/a.u. | Standardization IR2/IR1 |
|---|---|---|---|---|---|
| Comparative Example 1 | 479-692 | 11.338 | 1208-1644 | 2.336 | 0.206 |
| Comparative Example 2 | 481-741 | 22.947 | 1208-1644 | 1.962 | 0.086 |

Test Results

As shown in Table 3 and FIG. 7, in Examples 1 and 2, it was determined that a remaining organic component in the piezoelectric layer can be reduced, and the leakage current amount can be significantly reduced.

**Claims**

1. A piezoelectric substrate (400) comprising:

   a base body (2);
   an electrode (60A) formed at the base body; and
   a piezoelectric layer (70) formed at the electrode and containing potassium, sodium, niobium, lithium and copper, **characterized in that**
   a value of IR2/IR1 obtained by dividing an integrated intensity IR2 of a peak 2 by an integrated intensity IR1 of a peak 1, when a surface of the piezoelectric layer is measured by Fourier transform infrared spectroscopy, is less than 0.086,
   the peak 1 has a strongest area intensity among peaks detected at wavenumbers of 475 cm$^{-1}$ to 700 cm$^{-1}$, and the peak 2 has an area intensity that is a sum of area intensities of peaks detected at wavenumbers of 1200 cm$^{-1}$ to 1645 cm$^{-1}$.

2. The piezoelectric substrate (400) according to claim 1, wherein
   the IR2/IR1 is 0.05 or more.

3. The piezoelectric substrate (400) according to claim 1, wherein
   a content of the lithium is 10 mol% or less.

4. The piezoelectric substrate (400) according to claim 1, wherein
   a total content of copper is 5 mol% or less.

5. The piezoelectric substrate (400) according to claim 1, further comprising:
   an orientation control layer (61) between the piezoelectric layer (70) and the electrode (60A).

6. A piezoelectric element (300) comprising:

   the piezoelectric substrate (400) according to claim 1; and
   a second electrode (80) formed at the piezoelectric layer.

7. A piezoelectric element application device (1) comprising:
   the piezoelectric element (300) according to claim 6.

**Patentansprüche**

1. Piezoelektrisches Substrat (400), umfassend:

   einen Basiskörper (2);
   eine Elektrode (60A), die an dem Basiskörper gebildet ist; und
   eine piezoelektrische Schicht (70), die an der Elektrode gebildet ist und Kalium, Natrium, Niob, Lithium und Kupfer enthält, **dadurch gekennzeichnet, dass**

ein Wert von IR2/IR1, der durch Dividieren einer integrierten Intensität IR2 einer Spitze 2 durch eine integrierte Intensität IR1 einer Spitze 1 erhalten wird, wenn eine Oberfläche der piezoelektrischen Schicht durch Fourier-Transformations-Infrarotspektroskopie gemessen wird, kleiner als 0,086 ist,

die Spitze 1 eine stärkste Flächenintensität von Spitzen hat, die bei Wellenzahlen von 475 cm$^{-1}$ bis 700 cm$^{-1}$ erfasst werden, und die Spitze 2 eine Flächenintensität aufweist, die eine Summe von Flächenintensitäten von Spitzen ist, die bei Wellenzahlen von 1200 cm$^{-1}$ bis 1645 cm$^{-1}$ erfasst werden.

2. Piezoelektrisches Substrat (400) nach Anspruch 1, wobei
IR2/IR1 0,05 oder mehr ist.

3. Piezoelektrisches Substrat (400) nach Anspruch 1, wobei
ein Gehalt des Lithiums 10 Mol% oder weniger ist.

4. Piezoelektrisches Substrat (400) nach Anspruch 1, wobei
ein Gesamtgehalt von Kupfer 5 Mol% oder weniger ist.

5. Piezoelektrisches Substrat (400) nach Anspruch 1, weiter umfassend:
eine Ausrichtungssteuerschicht (61) zwischen der piezoelektrischen Schicht (70) und der Elektrode (60A).

6. Piezoelektrisches Element (300), umfassend:

das piezoelektrische Substrat (400) nach Anspruch 1; und
eine zweite Elektrode (80), die an der piezoelektrischen Schicht gebildet ist.

7. Anwendungsvorrichtung für piezoelektrische Vorrichtung (1), umfassend:
das piezoelektrische Element (300) nach Anspruch 6.

**Revendications**

1. Substrat piézoélectrique (400) comprenant :

un corps de base (2) ;
une électrode (60A) formée sur le corps de base ; et
une couche piézoélectrique (70) formée sur l'électrode et contenant du potassium, du sodium, du niobium, du lithium et du cuivre, **caractérisé en ce qu'**une valeur de IR2/IRI obtenue en divisant une intensité intégrée IR2 d'un pic 2 par une intensité intégrée IR1 d'un pic 1, lorsqu'une surface de la couche piézoélectrique est mesurée par spectroscopie infrarouge à transformée de Fourier, est inférieure à 0,086,
le pic 1 présente une intensité d'aire la plus forte parmi des pics détectés à des nombres d'onde de 475 cm$^{-1}$ à 700 cm$^{-1}$, et le pic 2 présente une intensité d'aire correspondant à la somme d'intensités d'aire de pics détectés à des nombres d'onde de 1200 cm$^{-1}$ à 1645 cm$^{-1}$.

2. Substrat piézoélectrique (400) selon la revendication 1, dans lequel
IR2/IR1 est de 0,05 ou plus.

3. Substrat piézoélectrique (400) selon la revendication 1, dans lequel
une teneur du lithium est de 10 mol% ou moins.

4. Substrat piézoélectrique (400) selon la revendication 1, dans lequel
une teneur totale de cuivre est de 5 mol% ou moins.

5. Substrat piézoélectrique (400) selon la revendication 1, comprenant en outre :
une couche de contrôle d'orientation (61) entre la couche piézoélectrique (70) et l'électrode (60A).

6. Élément piézoélectrique (300) comprenant :

le substrat piézoélectrique (400) selon la revendication 1 ; et

une deuxième électrode (80) formée sur la couche piézoélectrique.

7. Dispositif d'application d'élément piézoélectrique (1) comprenant :
   l'élément piézoélectrique (300) selon la revendication 6.

*FIG. 1*

EP 4 351 303 B1

*FIG. 2*

B—B'

300

80

70

60

61

52
50
51
2
10

X
Z
Y

## FIG. 3

EP 4 351 303 B1

# FIG. 4

FIG. 5

EP 4 351 303 B1

*FIG. 6*

A—A'

EP 4 351 303 B1

# FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013225605 A
- US 2013064970 A
- EP 3336912 A
- US 2021036212 A1